# EUROPÄISCHE PATENTSCHRIFT

(11) **EP 3 194 992 B1**
(45) Veröffentlichungstag und Bekanntmachung des Hinweises auf die Patenterteilung: **26.12.2018**
(21) Anmeldenummer: 15766144.8
(22) Anmeldetag: 17.09.2015
(51) Int. Cl.: G01R 33/02

(54) **SPULE MIT HOHER GÜTE**
HIGH-QUALITY COIL
BOBINE DE HAUTE QUALITÉ

(30) Priorität: 19.09.2014 DE 102014218874
(43) Veröffentlichungstag der Anmeldung: 26.07.2017
(73) Patentinhaber: Forschungszentrum Jülich GmbH, 52425 Jülich (DE)
(72) Erfinder: APPELT, Stephan, 52070 Aachen (DE); SÜFKE, Martin, 50354 Hürth (DE); LIEBISCH, Bernd Alexander, 52064 Aachen (DE)
(74) Vertreter: Gille Hrabal
(86) Internationale Anmeldenummer: PCT/EP2015/071345
(87) Internationale Veröffentlichungsnummer: WO 2016/042086

(56) Entgegenhaltungen:
- EP-A1- 0 092 018
- DE-A1- 19 742 380
- DE-A1-102008 016 488
- GB-A- 2 382 876
- JP-A- 2014 120 325
- US-A- 5 742 213

## Beschreibung

Die Erfindung betrifft eine Spule. Eine Spule wird durch mindestens eine Wicklung eines elektrischen Leiters gebildet. Der elektrische Leiter kann auf einem Spulenkörper aufgewickelt sein, der die Eigenschaften der Spule nicht beeinflusst und daher zum Beispiel aus Kunststoff besteht. Die Spule kann einen Kern umfassen, um den der elektrischen Leiter ein oder mehrmals gewickelt ist. Der Kern verändert die Eigenschaft der Spule und zwar insbesondere die Induktivität und Güte. Die beiden Enden des elektrischen Leiters bilden die beiden Anschlüsse der Spule.

Als elektrischer Leiter wird beispielsweise ein Draht oder eine Litze eingesetzt. Eine Litze besteht aus einer Vielzahl von zum Beispiel parallel verlaufenden Einzeldrähten. Die Einzeldrähte können wendelförmig, also in Form einer Helix, verlaufen.

Um elektromagnetische Signale messen zu können, umfasst eine dafür geeignete Messvorrichtung einen elektrischen Schwingkreis. Ein Schwingkreis weist eine Spule und eine Kapazität auf. Um einen Schwingkreis mit geringer Dämpfung zu erhalten, werden u. a. Spulen mit hoher Güte benötigt. Die Güte einer Spule ist das Produkt aus der Messfrequenz und dem Verhältnis von Induktivität zu Widerstand.

Eine Spule mit einem gewickelten elektrischen Leiter, dessen Enden die beiden elektrischen Anschlüsse der Spule bilden, ist aus der US 512,340 bekannt.

Neben einer Spule mit einem elektrischen Leiter und zwei elektrischen Anschlüssen gibt es auf dem Gebiet der Stromversorgung und Transformatoren Bauteile mit einer Mehrzahl von gemeinsam gewickelten elektrischen Leitern mit einer Vielzahl von elektrischen Anschlüssen (US 5,640,314). Elektrische Leiter solcher Bauteile mit zumindest vier elektrischen Anschlüssen können verdrillt sein (RF Circuit Design, 2nd Edition, Christopher Bowick, ISBN 978-0750685184).

Es ist Aufgabe der Erfindung, eine Spule mit vorteilhaften Eigenschaften für einen Schwingkreis, insbesondere für eine Messvorrichtung für elektromagnetische Signale, bereitzustellen.

Die Aufgabe der Erfindung wird durch eine Spule mit den Merkmalen des Anspruchs 1 gelöst. Vorteilhafte Ausgestaltungen ergeben sich aus den Unteransprüchen.

Die Spule weist einen elektrischen Leiter auf, dessen Enden die beiden Anschlüsse der Spule bilden. Gewickelte Abschnitte des elektrischen Leiters sind miteinander verdrillt, also wendelfömig umeinander gewickelt. Der elektrische Leiter ist grundsätzlich von einer Isolation, zum Beispiel aus Kunststoff oder Lack, umgeben.

Durch die Verdrillung werden Abstandsvergrößerungen zwischen benachbarten Leitungsabschnitten innerhalb der Wicklungen erzielt. Es resultiert eine verbesserte Güte der Spule.

In einem Schwingkreis trägt eine solche Spule mit verbesserter Güte dazu bei, die gesamte Güte des Schwingkreises zu verbessern. Umfasst eine Messvorrichtung für die Messung von elektromagnetischen Signalen einen solchen Schwingkreis, so resultiert eine Messvorrichtung, mit der verbessert ein elektromagnetisches Signal gemessen werden kann. Insbesondere kann das Signal-Rausch-Verhältnis bei einer solchen Messvorrichtung verbessert werden.

Ein elektrischer Leiter kann ein Draht oder eine Litze sein. Für den Einsatz in einem Schwingkreis ist eine Litze vorteilhaft. Der elektrische Leiter kann aus einer Mehrzahl von Drähten oder Litzen hergestellt sein, die elektrisch miteinander zu einem elektrischen Leiter der Spule verbunden worden sind.

Es werden beispielsweise zunächst elektrisch voneinander getrennte elektrische Leiter umeinander gewickelt. Es werden also beispielsweise zwei Drähte oder zwei Litzen oder eine Litze und ein Draht miteinander verdrillt. Ein Ende des einen elektrischen Leiters wird mit einem Ende des anderen elektrischen Leiters elektrisch verbunden und zwar insbesondere mit einem gegenüber liegenden Ende. Die elektrische Verbindung kann beispielsweise eine Lötverbindung oder Klemmverbindung sein. Die beiden verbleibenden Enden bilden die beiden Anschlüsse der Spule. Die miteinander verdrillten Abschnitte werden zur Spule gewickelt, also zum Beispiel auf einen Spulenkörper aufgewickelt. Eine derart hergestellte Spule ermöglicht mit geringem technischem Aufwand die Herstellung einer Spule mit hoher Güte.

Drähte oder Litzen der Spule bestehen vorteilhaft aus Kupfer, Silber oder Gold. Dies führt zu einem geringen Widerstand und daher zu einer hohen Güte der Spule und damit zu einer hohen Güte eines Schwingkreises, der eine solche Spule umfasst. Dies trägt dazu bei, das genannte Signal-Rausch-Verhältnis in einer Messvorrichtung mit einem solchen Schwingkreis weiter zu verbessern.

Vorzugsweise wird die Spule durch zumindest eine Litze gebildet, deren dünne Drähte voneinander elektrisch isoliert sind und zwar insbesondere durch isolierende Lackschichten, um so zu einem weiter verbesserten genannten Signal - Rausch - Verhältnis bei einer Messvorrichtung für die Messung von elektromagnetischen Signalen zu gelangen. Die einzelnen Drähte sind innerhalb der Wicklungen also durch elektrische Isolatorschichten voneinander getrennt.

Zwei verflochtene oder verdrillte elektrische Leiter, so zum Beispiel Kupferdrähte oder Kupferlitzen, gleicher Länge werden in einer Ausgestaltung mit wenigen Windungen um einen Kern, vorzugsweise einen Ferritkern, gewickelt. Die Zahl der Windungen hängt von gewählten Detektionsfrequenzen ab. Bis zu 150 Wicklungen haben sich für niedrige Frequenzen von bis zu 20 kHz als geeignet herausgestellt. Die Spule weist für niedrige Frequenzen wenigstens 5 Wicklungen, vorteilhaft wenigstens 10 Wicklungen auf. Eine Wicklung liegt vor, wenn die miteinander verdrillten elektrischen Leiter einmal zum Beispiel um einen Spulenkörper oder um einen Spulenkern gewickelt worden sind. Das verflochtene Windungspaar aus mehradrigem Kupfer oder Litzendraht minimiert vorteilhaft Skin- und Proximityeffekte und den damit verbundenen AC-Widerstand erheblich.

Die Spule weist eine Mehrzahl von Wicklungen eines elektrischen Leiters sowie eine Mittelanzapfung auf. Eine Mittelanzapfung ist ein zusätzlicher elektrischer Anschluss, der elektrisch gesehen zwischen beiden Anschlüssen des elektrischen Leiters angeordnet ist.

Durch die Mittelanzapfung können Schwingneigungen eines Schwingkreises umfassend eine erfindungsgemäße Spule durch Erdung der Mittelanzapfung unterdrückt werden und zwar besonders gut, wenn die Mittelanzapfung elektrisch gesehen in etwa mittig, vorzugsweise genau mittig, angeordnet ist. Dies wirkt sich positiv auf ein Signal-Rausch-Verhältnis aus, wenn der Schwingkreis für die Messung von elektromagnetischen Signalen eingesetzt wird. Eine solche Spule mit Mittelanzapfung, wie im Anspruch 1 definiert, eine eigenständige Erfindung dar, die mit den vorgenannten Merkmalen einzeln oder in beliebiger Kombination kombiniert werden kann.

Eine Spule mit dieser Mittelanzapfung ist von besonderem Vorteil, wenn die Spule Teil eines Schwingkreises in einer Messvorrichtung für elektromagnetische Strahlung ist und das Messsignal durch einen hochohmigen Differenzverstärker verstärkt wird. Insbesondere durch diese Kombination wird ein besonders gutes Signal - Rausch - Verhältnis erzielt.

Zur Herstellung einer Spule mit dieser Mittelanzapfung werden beispielsweise zwei Drähte oder Litzen (erster und zweiter Draht bzw. erste und zweite Litze) miteinander verdrillt oder lediglich geradlinig parallel zueinander angeordnet. Anschließend werden die beiden miteinander verdrillten oder parallel und geradlinig verlaufenden Drähte gewickelt, so zum Beispiel um einen Kern herum. Ein Anschluss des ersten elektrischen Leiters sowie ein entgegengesetzter Anschluss des zweiten elektrischen Leiters werden elektrisch miteinander verbunden und als dritter Anschluss bereitgestellt, der dann die Mittelanzapfung bildet, die für einen Einsatz in einem Schwingkreis geerdet wird. Die beiden anderen verbleibenden Anschlüsse bilden dann die beiden Anschlüsse der Spule. Es können so unabhängig von einer Verdrillung Vorteile erzielt werden, die bei einer Messvorrichtung für elektromagnetische Signale ein verbessertes Signal-Rausch-Verhältnis bewirken. Insbesondere kann so einen Mittelanzapfung genau mittig angeordnet werden, wenn die gewickelten Leiterbahnenbereiche von zwei Leitern, die wie beschrieben miteinander für die Bereitstellung eines Anschlusses der Mittel anzapfen elektrisch verbunden wurden, gleich lang sind. Vorzugsweise beträgt der Längenunterschied zwischen den beiden gewickelten Leiterbahnbereichen nicht mehr als 10 %, bevorzugt nicht mehr als 1%,, besonders bevorzugt weniger als 1/1000, um eine Mittelanzapfung geeignet anzuordnen. Ein Signal-Rausch-Verhältnis bei einer Messvorrichtung zur Messung von elektromagnetischen Signalen kann so erheblich verbessert werden.

Die beiden Leiterbahnabschnitte, die miteinander verdrillt sind oder aber zueinander parallel verlaufen, um gemeinsam gewickelt zu werden, können miteinander mechanisch verbunden sein, so zum Beispiel durch Verkleben oder durch Eingießen in Harz, durch Umspinnen mit Fasermaterial oder Einführen in einen Schlauch. Die Wechselstromwiderstände der beiden Leiterbahnabschnitte und/oder die Induktivitäten der beiden Leiterbahnabschnitte sind erfindungsgemäss gleich, um vorteilhaft Messungen mit einer Messvorrichtung für elektromagnetische Signale durchführen zu können und zwar insbesondere bei Vorhandensein eines hochohmigen Differenzverstärkers wie im Fall eines Instrumentverstärkers.
Eine erfindungsgemäße Spule ist grundsätzlich ein eigenständiges Bauteil, welches mit der beanspruchten Mittelanzapfung grundsätzlich über nur einen elektrischen Leiter mit drei elektrischen Anschlüssen verfügt. Wäre keine Mittelanzapfung vorhanden, so verfügte der Gegenstand grundsätzlich über nur einen elektrischen Leiter mit genau zwei elektrischen Anschlüssen.
Eine Messvorrichtung mit gutem Signal-Rausch-Verhältnis umfasst einen elektromagnetischen Schwingkreis mit einer Aufnehmerspule, einer vorzugsweise abstimmbaren Kapazität und eine Filterspule. Als Filterspule dient die anspruchsgemäße Spule mit Mittelanzapfung. Durch die Aufnehmerspule wird das zu detektierende elektromagnetische Signal aufgenommen. Filterspule und Kapazität weisen vorteilhaft eine hohe Güte von wenigstens 100, vorteilhaft von wenigstens 200, besonders bevorzugt von wenigstens 500 auf. Das Messsignal steht dann an den beiden Anschlüssen der Filterspule mit gutem Signal - Rausch - Verhältnis zur Verfügung.

Es resultiert eine Messvorrichtung, die als Bandpassfilter mit einem relativ schmalen Band wirkt. Bei entsprechender Abstimmung wird das Nutzsignal durchgelassen. Rauschsignale im angrenzenden Frequenzbereich werden herausgefiltert, so dass bereits deshalb ein gutes Signal - Rausch - Verhältnis erzielt wird. Vor allem aber gelingt eine geeignete Spannungsverstärkung, die maßgeblich zu einem guten Signal - Rausch - Verhältnis beiträgt.
Es kann sehr flexibel und robust im praktischen Einsatz gemessen werden. Die gesamte notwendige Hardware ist miniaturisierbar und erlaubt es, mobile ESR- oder NMR-Spektroskopie im Frequenzbereich von 1 kHz - 40 MHz mit Mikrospulen ohne den Einsatz von supraleitenden Magneten durchzuführen. Insbesondere kann eine ESR- oder NMR-Spektroskopie bei Frequenzen unterhalb 10 MHz und vor allem auch unterhalb von 1 MHz durchgeführt werden, um den apparativen Aufwand gering halten zu können Anwendungsgebiete sind die chemische Analytik, die Sensortechnologie sowie Medizinwissenschaften.

Erfindungsgemäss umfasst die Spule neben zwei Anschlüssen für die Spule noch einen dritten Anschluss für die Mittelanzapfung, und sind die Wechselstromwiderstände und/oder Induktivitäten der gewickelten, verdrillten Leiterbahnabschnitte zwischen Anschlüssen aus bereits genannten Gründen gleich und zwar einerseits dem Abschnitt zwischen dem einen Spulenanschluss und dem Anschluss für die Mittelanzapfung und andererseits zwischen dem Abschnitt zwischen dem anderen Spulenanschluss und dem Anschluss für die Mittelanzapfung. Die beiden Abschnitte gleichen sich also hinsichtlich der genannten elektrischen Eigenschaften.

Es zeigen:
- Figur 1:: Aufbau einer Meßvorrichtung mit Spule mit Mittelanzapfung;
- Figur 2:: miteinander verdrillte elektrische Leiter für Spule mit Mittelanzapfung;
- Figur 3:: zur Spule gewickelte Leiterbahnen;
- Figur 4:: Spule mit Mittelanzapfung;
- Figur 5:: Spule mit Mittelanzapfung und Spulenkern.

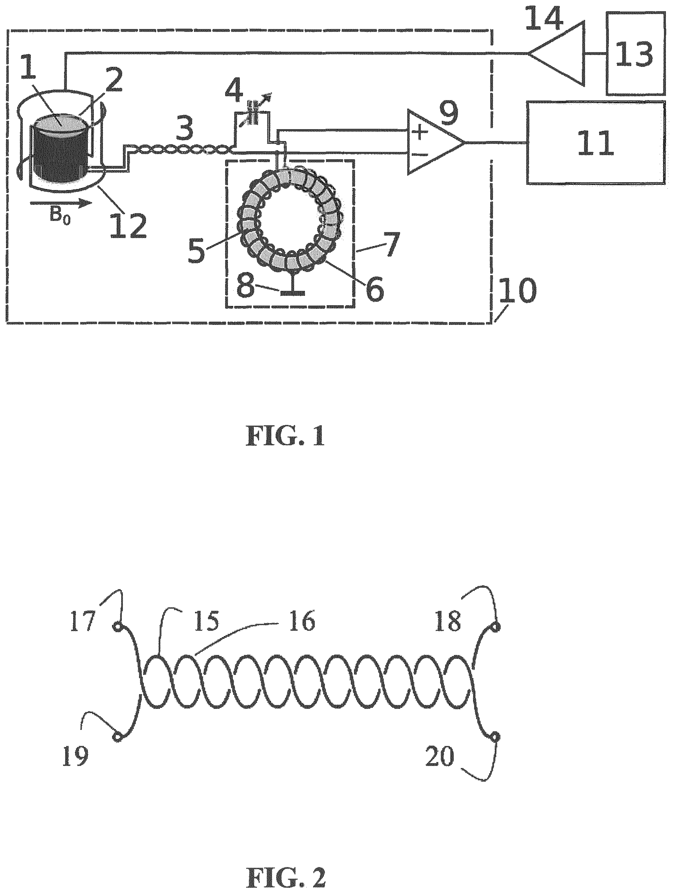

Die Figur 1 zeigt eine um eine Probe 1 gewickelte Aufnehmerspule 2 beliebiger Bauform. Die Aufnehmerspule 2 ist über eine verlustarme Transferleitung 3 und einer abstimmbaren Kapazität 4 hoher Güte (Qc ∼ 10000) mit einer externen hochgütigen Filterspule 6 mit einem Ferritkern 5 verbunden. Die Transferleitung umfasst zwei elektrische Leiter, die jeweils entweder aus einer mehradrigen Kupferleitung mit großem Querschnitt (> 1 mm²) und minimalen kapazitiven dielektrischen Verlusten aufgrund einer Teflon-Isolation bestehen oder aus dickem niederohmigen Litzendraht (1000 x 0.05 mm) mit vernachlässigbarem Skin- und Proximityeffekt bei Frequenzen unterhalb 1 MHz. Die beiden Leitungen sind wie dargestellt umeinander gewickelt, also miteinander verzwirbelt bzw. verdrillt. Im Fall einer Teflonisolation ist jeder Leiter von Teflon umhüllt. Zusätzlich befinden sich die beiden miteinander verdrillten Leiter der Transferleitung 3 in einer Teflonhülle.

Beispielsweise ein von der Aufnehmerspule aufgenommenes oszillierendes NMR-Signal (sog. freier Induktionszerfall, FID) wird über die Transferleitung 3 mit geringen Verlusten zur Filterspule 6 geleitet. Wegen der hohen Güte Q_{E} der Filterspule 6 wird das NMR-Signal gegenüber dem Rauschen um den reduzierten Faktor Q_{red} = Q_{E}/(1+R_{I}/R_{E}) >> 100 überhöht mit R_{I} = Wechselstromwiderstand der Aufnehmerspule und R_{E} = Wechselstromwiderstand der Filterspule. Die Wechselspannung an der Filterspule wird über zwei elektrisch leitende Verbindungen in den invertierenden und nichtinvertierenden Eingang eines Differenzverstärkers 9 geleitet und dort weiter verstärkt. Um die Schwingneigung des sehr empfindlichen Resonators in Verbindung mit dem Differenzverstärker 9 zu unterdrücken, ist eine geerdete Mittelanzapfung 8 an der Filterspule 6 vorhanden. Darüber hinaus sorgt die Mittelanzapfung 8 für die Ableitung der technisch unvermeidbaren Bias-Ströme des Differenzverstärkers 9.

Die Filterspule 6 ist durch eine Abschirmung 7 gesondert magnetisch abgeschirmt.

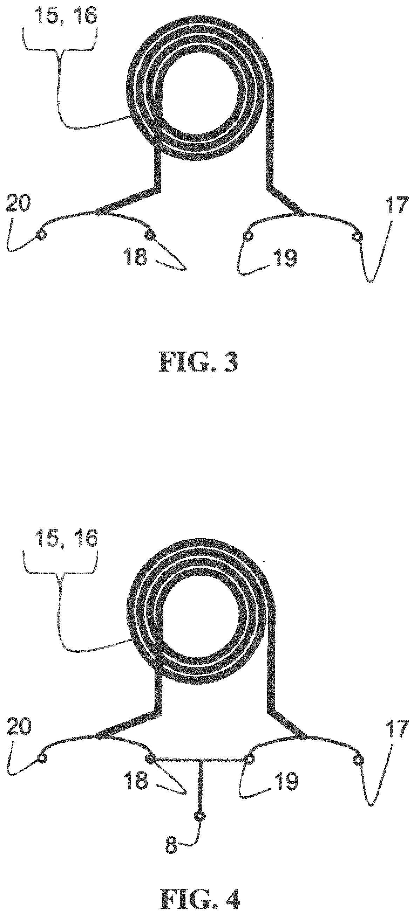

In der Figur 2 werden zwei miteinander verdrillte elektrische Leiter 15 und 16 gezeigt, wie sie für die Filterspule 6 eingesetzt sind. Die beiden elektrischen Leiter 15 und 16 weisen gleiche oder zumindest sehr ähnliche Widerstandswerte auf und gleiche Induktivität. Die elektrischen Leiter 15 und 16 sind elektrisch voneinander isoliert. Außerdem sind die beiden elektrischen Leiter 15 und 16 gleich lang. Die verdrillten Drähte 15 und 16 werden gemeinsam um den Kern 5 gewickelt. Ein Ende des einen elektrischen Leiters 15, so zum Beispiel das in der Figur 2 links gezeigte Ende 19, und das gegenüberliegende Ende des anderen Leiters 16, also dann das rechts gezeigte Ende 18, werden elektrisch miteinander verbunden und bilden so die Mittelanzapfung 8 (siehe Figur 4), die geerdet wird. Die verbleibenden Enden 17 und 20 der elektrischen Leiter 15 und 16 werden dann mit dem vorzugsweise abstimmbaren Kondensator 4 einerseits und einem elektrischen Leiter der Transferleitung 3 andererseits elektrisch verbunden. Die Enden 17 und 20 bilden also dann die beiden Anschlüsse für die Spule 6. Die elektrisch miteinander verbundenen Enden 18 und 19 bilden die Mittelanzapfung 8.

Die Figur 3 verdeutlicht ein Wickeln der beiden elektrischen Leiter 15 und 16, beispielsweise um einen Spulenkörper herum.

Die Figur 4 verdeutlicht eine mögliche Form eines gewickelten elektrischen Leiters, bestehend aus elektrisch miteinander verbundenen Leitern 15, 16, sowie die daraus resultierenden Anschlüsse 17, 18, 19 und 20. Die Anschlüsse 18 und 19 sind in einem Arbeitsschritt elektrisch verbunden worden und bilden die Mittelanzapfung. Die Anschlüsse 17 und 20 stellen die Anschlüsse für die Spule dar. Die elektrischen Leiter 15 und 16 können anfänglich auch parallel verlaufen, also nicht miteinander verdrillt worden sein, um bereits daraus eine Spule mit vorteilhaften Eigenschaften aufgrund der Mittelanzapfung zu wickeln.

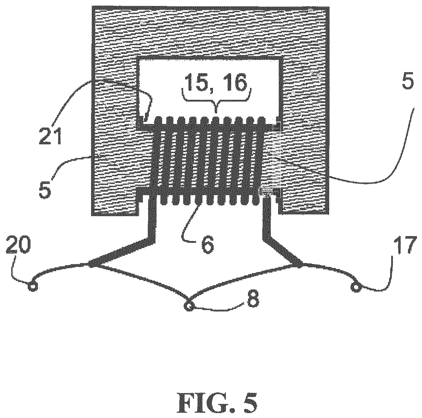

Die Figur 5 zeigt eine so hergestellte Spule mit einem Spulenkörper 21 und einem Spulenkern 5.

Eine Filterspule 6 mit Ferritkern 5 kann klein sein und kann mit geringem technischen Aufwand hergestellt werden und daher preisgünstig sein. Es sind Güten bis zu ∼ 500 realisierbar.

## Patentansprüche

1. Spule mit einem gewickelten elektrischen Leiter, dessen Enden (17, 20) die beiden Anschlüsse der Spule (6) bilden, wobei gewickelte Abschnitte (15, 16) des elektrischen Leiters miteinander verdrillt sind
und die verdrillten Abschnitte aus zumindest zwei elektrischen Leitern (15, 16) gebildet sind, die elektrisch miteinander verbunden worden sind.
wobei gegenüberliegende Enden (18, 19) der beiden elektrischen Leiter (15, 16) elektrisch so miteinander verbunden sind, dass diese eine Mittelanzapfung (8) bilden,
**dadurch gekennzeichnet, dass**
die gewickelten, miteinander verdrillten Leiterbahnbereiche der beiden elektrischen Leiter (15, 16) gleich lang sind und/oder deren Wechselstromwiderstände gleich sind und/oder deren Induktivitäten gleich sind.

2. Spule nach einem der vorhergehenden Ansprüche, **dadurch gekennzeichnet, dass** die miteinander verdrillten Abschnitte (15, 16) des gewickelten elektrischen Leiters der Spule um einen Kern gewickelt sind, der insbesondere aus Ferrit besteht.

3. Spule nach einem der vorhergehenden Ansprüche, **dadurch gekennzeichnet, dass** der gewickelte elektrische Leiter (15, 16) der Spule eine Litze ist.

4. Spule nach dem vorhergehenden Anspruch, **dadurch gekennzeichnet, dass** die Drähte der Litze (15, 16) voneinander elektrisch isoliert sind und zwar insbesondere durch elektrisch isolierende Lackschichten.

5. Spule nach einem der vorhergehenden Ansprüche, **dadurch gekennzeichnet, dass** der gewickelte elektrische Leiter der Spule aus Kupfer, Silber oder Gold besteht.

6. Spule nach einem der vorhergehenden Ansprüche, **dadurch gekennzeichnet, dass** wenigstens 5, vorzugsweise wenigstens 10 Wicklungen vorhanden sind und / oder bis zu 150 Wicklungen vorhanden sind.

7. Spule nach einem der vorhergehenden Ansprüche, **dadurch gekennzeichnet, dass** die Güte der Spule mehr als 100, vorteilhaft mehr als 200, besonders bevorzugt wenigstens 500 beträgt.

8. Spule nach einem der vorhergehenden Ansprüche, **dadurch gekennzeichnet, dass** maximal drei elektrische Anschlüsse (8, 17, 20) vorhanden sind und vorzugsweise Wechselstromwiderstände und/oder Induktivitäten zwischen Anschlüssen (8, 17 20) gleich sind.

9. Elektrischer Schwingkreis umfassend eine Spule (6) nach einem der vorhergehenden Ansprüche.

10. Messvorrichtung für die Messung von elektromagnetischen Signalen umfassend einen elektrischen Schwingkreis (4, 6) nach dem vorhergehenden Anspruch.

## Claims

1. Coil with a wound electric conductor, whose ends (17, 20) form the both terminals of the coil (6), wherein wound sections (15, 16) of the electric conductor are twisted together
and the twisted sections are formed of at least two electric conductors (15, 16), which were electrically connected together,
wherein opposite ends (18, 19) of the both electric conductors (15, 16) are electrically connected together in such a way that they form a center tapping (8),
**characterized in that**
the wound, twisted together conductor path sections of both of the electric conductors (15, 16) are equally long and/or their alternating current resistances are equal and/or their inductances are equal.

2. Coil of one of the preceding claims, **characterized in that** the twisted together sections (15, 16) of the wound electric conductor of the coil are wound around a core, which in particular consists of ferrite.

3. Coil of one of the preceding claims, **characterized in that** the wound electric conductor (15, 16) of the coil is a braid.

4. Coil of the preceding claim, **characterized in that** the wires of the braid (15, 16) are electrically insulated from each other, namely in particular by means of electrically insulating varnish layers.

5. Coil of one of the preceding claims, **characterized in that** the wound electric conductor of the coil consists of copper, silver or gold.

6. Coil of one of the preceding claims, **characterized in that** there are at least 5, preferably at least 10 windings and / or there are up to 150 windings.

7. Coil of one of the preceding claims, **characterized in that** the quality of the coil amounts to more than 100, advantageously more than 200, particularly preferred at least 500.

8. Coil of one of the preceding claims, **characterized in that** there are at most three electric terminals (8, 17, 20) and preferably alternating current resistances and/or inductances between terminals (8, 17, 20) are equal.

9. Electric oscillating circuit comprising a coil (6) of one of the preceding claims.

10. Measuring device for the measurement of electromagnetic signals comprising an electric oscillating circuit (4, 6) of the preceding claim.

## Revendications

1. Bobine ayant un conducteur électrique enroulé dont les extrémités (17, 20) forment les deux bornes de la bobine (6),
dans laquelle des parties enroulées (15, 16) du conducteur électrique sont torsadées les unes avec les autres
et lesdites parties torsadées sont formées d'au moins deux conducteurs électriques (15, 16) qui ont été reliés électriquement entre eux,
dans laquelle les extrémités opposées (18, 19) des deux conducteurs électriques (15, 16) sont reliées électriquement l'une à l'autre de sorte qu'elles forment une prise centrale (8),
**caractérisée en ce que** les régions de pistes conductrices torsadées et enroulées des deux conducteurs électriques (15, 16) sont de longueur égale et/ou leurs résistances de courant alternatif (15, 16) sont égales et/ou leurs inductances sont égales.

2. Bobine selon l'une des revendications précédentes, **caractérisée en ce que** les parties torsadées (15, 16) l'une avec l'autre du conducteur électrique enroulé de la bobine sont enroulées autour d'un noyau constitué notamment de ferrite.

3. Bobine selon l'une des revendications précédentes, **caractérisée en ce que** le conducteur électrique enroulé (15, 16) de la bobine est un fil de Litz.

4. Bobine selon la revendication précédente, **caractérisée en ce que** les brins du fil de Litz (15, 16) sont isolés électriquement les uns des autres, en particulier par des couches de laque électriquement isolantes.

5. Bobine selon l'une des revendications précédentes, **caractérisée en ce que** le conducteur électrique enroulé de la bobine est en cuivre, argent ou or.

6. Bobine selon l'une des revendications précédentes, **caractérisée en ce qu'**au moins 5, de préférence au moins 10 enroulements sont présents et/ou jusqu'à 150 enroulements sont présents.

7. Bobine selon l'une des revendications précédentes, **caractérisée en ce que** la qualité de la bobine est supérieure à 100, avantageusement supérieure à 200, particulièrement de préférence au moins 500.

8. Bobine selon l'une des revendications précédentes, **caractérisée en ce qu'**au maximum trois connexions électriques (8, 17, 20) sont présentes et de préférence des résistances et/ou inductances de courant alternatif entre les connexions (8, 17, 20) sont identiques.

9. Circuit oscillant électrique comprenant une bobine (6) selon l'une des revendications précédentes.

10. Dispositif de mesure pour la mesure de signaux électromagnétiques comprenant un circuit électrique oscillant (4, 6) selon la revendication précédente.
